# EUROPEAN PATENT SPECIFICATION

(11) **EP 4 280 466 B1**
(45) Date of publication and mention of the grant of the patent: **25.02.2026**
(21) Application number: 23202041.2
(22) Date of filing: 10.12.2019
(51) Int. Cl.: H03H 7/38, H04B 1/04

(54) **COMPACT ANTENNA IMPEDANCE TUNER**
KOMPAKTER ANTENNENIMPEDANZABSTIMMER
SYNTONISEUR D'IMPÉDANCE D'ANTENNE COMPACT

(43) Date of publication of application: 22.11.2023
(62) Divisional of application: 19820726.8
(73) Proprietor: Telefonaktiebolaget LM Ericsson (publ), 164 83 Stockholm (SE)
(72) Inventor: Sjöland, Henrik, SE-224 68 LUND (SE); Abdulaziz, Mohammed, SE-224 72 LUND (SE)
(74) Representative: Ericsson

(56) References cited:
- EP-A1- 2 549 645
- US-A- 5 986 617
- US-B1- 8 929 945

## Description

### TECHNICAL FIELD

Embodiments herein relate to a circuit for impedance transforming. In particular, they relate to antenna impedance tuners with a tapped transformer and programmable capacitors.

### BACKGROUND

A wireless communication device or equipment usually comprises an antenna, a transceiver comprising transmitter and receiver, and a baseband processing unit. The transmitter typically up-converts baseband signals to Radio Frequency (RF) signals for transmission, and the receiver down-converts received RF signals to baseband signals for further processing in the baseband processing unit.

In the wireless communication device, the antenna impedance will have large variations, for instance when a user holds the device or places it in different environments. Since transceivers are designed for certain antenna impedance, e.g. 50Ω, significant deviations from that value will cause performance degradation. To counteract variations in the impedance presented to the transceiver, an antenna impedance tuner may be used. It can transform different antenna impedances to impedances closer to what the transceiver is designed for, and typically consists of switches and passive components, e.g. inductors and capacitors. The switches can be turned on and off representing different states, in which the tuner performs different impedance transformations. Depending on integration level some components, or all, may be implemented on chip. The lowest loss is achieved if inductors are off-chip, in which case they may have very high quality factor. The loss is one of the key parameters of an antenna tuner. Another important parameter is the size of the so-called matching domain, i.e. how wide range of antenna impedances that can be transformed to a value close to the nominal transceiver impedance. Linearity is also important, i.e. how much distortion is caused by primarily the switches, and how much power may be handled before signal compression and breakdown. Cost and size of the implementation, and simplicity of controlling the tuner to certain impedance, are other key parameters when designing a tuner for an application.

While antenna impedance tuners are beneficial to transceivers in the wireless communication devices in general, they are even more important in upcoming full duplex systems. In such systems the transmitter and receiver operate simultaneously at the same frequency, and the receiver and transmitter are connected to the antenna through an isolator or circulator. The isolation from transmit to receive port will depend on the impedance presented to its antenna port. It is important to reduce variations in that impedance. An antenna impedance tuner may then improve the isolation and thus the performance of a full duplex transceiver.

In J. Lindstrand, et. al., "A low band cellular antenna impedance tuner in 130nm CMOS-SOI technology", ESSCIRC 2014, pp. 459-462, a high performance tuner in Silicon on Insulator (SOI) Complementary Metal Oxide Semiconductor (CMOS) technology using off chip inductors is disclosed. While this is suitable for some applications requiring the lowest possible loss, other applications may benefit more from a fully integrated design to reduce cost and physical size.

US5986617A discloses an unbalanced to balanced antenna matching unit operating over a relatively large frequency range by utilizing multiple transformers connected in series, with a set of bypass switches used to control the number of transformers that are "active" in the matching unit at any particular time. The multiband antenna matching unit may efficiently shift the operating frequency by bypassing at least one of the multiple transformers of the matching unit while maintaining the same transformation ratio.

In prior art solutions, antenna impedance tuners also tend to have a complicated behavior of the matching domain, which may also be rather different at different frequencies. To simplify the control of the tuner it may be preferable to have a more regular behavior that is more uniform with frequency. The designs using off-chip inductors tend to use several separate inductors, which translate into large chip area in a fully integrated design.

### SUMMARY

Embodiments herein provide a circuit for impedance transforming which is suitable for full integration and has improved flexibility, cost, size and matching domain behavior.

To minimize chip area, in a fully integrated tuner it may be more suitable to use a single inductor or transformer structure.

According to one aspect of embodiments herein, there is provided a chip having integrated thereon a circuit that comprises a first port, a second port and a tapped transformer comprising a first winding and a second winding. The first winding comprises a first terminal, a second terminal and a number of taps connected at different positions on the first winding between the first and second terminals. The second winding comprises a first terminal, a second terminal and a number of taps connected at different positions on the second winding between the first and second terminals. The circuit further comprises a first programmable capacitor connected between the first and second terminals of the first winding and a first set of switches connected between the number of taps on the first winding and a terminal of the first port. The circuit further comprises a second programmable capacitor connected between the first and second terminals of the second winding and a second set of switches connected between the number of taps on the second winding and a terminal of the second port. In some embodiments, the circuit is configured to transform impedance between a first circuit connected to the first port and a second circuit connected to the second port by selectively connecting the first circuit to one of the taps on the first winding via the first set of switches and selectively connecting the second circuit to one of the taps on the second windings via the second set of switches.

The circuit for impedance transforming according to the embodiments herein may be used as an antenna impedance tuner. The core of the tuner is a tapped transformer, with multiple taps on both windings. The use of a single transformer reduces chip area compared to using multiple separate inductors. By using switches to connect to different taps on the two transformer sides, the antenna impedance may be transformed both up and down. Both transformer windings are shunted with programmable capacitors. If these capacitors are set to resonate with the inductance of the transformer at the operating frequency, the tuner transforms between real valued impedances. The transformation ratio may be programmed by the switches selecting different taps for connection to the tuner ports. If transformation from complex antenna impedance to real valued impedance is desired, the capacitors may be programmed to a smaller or larger value than the resonance value. The impedance will then move along a circle in the Smith chart, sweeping over the capacitive and inductive half. Sweeping the capacitance for the different tap settings will create non-overlapping circle arcs covering an area of the Smith chart. This represents a matching domain that is unusually well-ordered, and thus supports simpler control of the impedance tuner.

Therefore, embodiments herein provide a circuit for impedance transforming with improved flexibility, cost, size, and matching domain behavior when controlling the impedance transforming.

### BRIEF DESCRIPTION OF THE DRAWINGS

Examples of embodiments herein are described in more detail with reference to attached drawings in which:
- Figure 1: is a schematic view of a circuit for impedance transforming according to embodiments herein;
- Figure 2: is a schematic view of a single-ended impedance tuner according to embodiments herein;
- Figure 3: is a schematic view of a differential to single-ended impedance tuner according to embodiments herein;
- Figure 4: is a schematic view of a single-ended to differential impedance tuner according to embodiments herein;
- Figure 5: is a schematic view of a differential impedance tuner according to embodiments herein;
- Figure 6: shows an example layout of a tapped transformer with single-ended structure according to embodiments herein;
- Figure 7: shows an example layout of a tapped transformer with differential structure according to embodiments herein;
- Figure 8: shows simulation results for an impedance transforming circuit according to embodiments herein; and
- Figure 9: is a block diagram illustrating a wireless communication device in which an impedance transforming circuit according to embodiments herein may be implemented.

### DETAILED DESCRIPTION

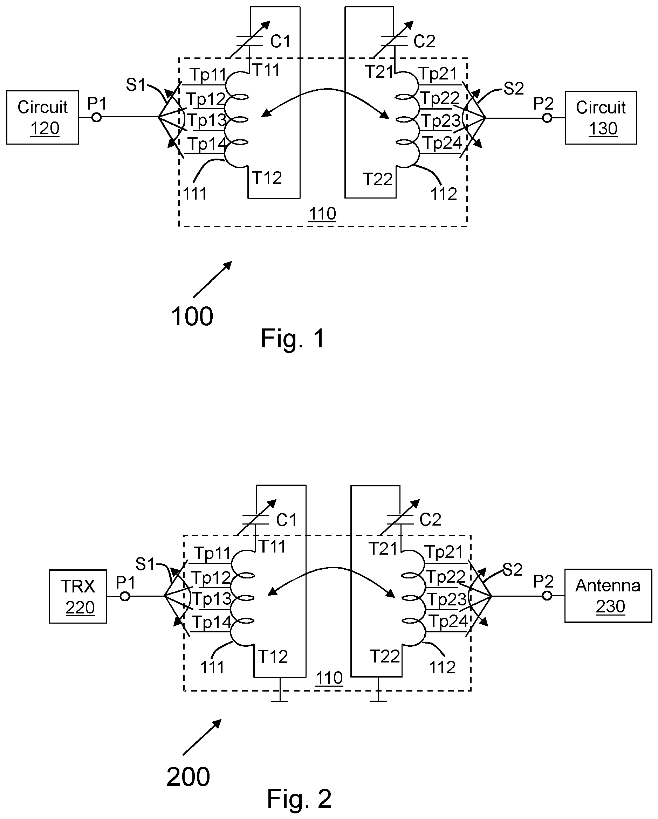

**Figure 1** shows a schematic view of a circuit **100** for impedance transforming according to embodiments herein. The impedance transforming circuit 100 comprises a first port **P1** and a second port **P2,** a tapped transformer **110** comprising a first winding **111** and a second winding **112.**

The first winding 111 comprises a first terminal **T11,** a second terminal **T12** and a number of taps **Tp11, Tp12, Tp13, Tp14...** connected at different positions on the first winding 111 between the first and second terminals T11, T12.

The second winding 112 comprises a first terminal **T21,** a second terminal **T22** and a number of taps **Tp21, Tp22, Tp23, Tp24...** connected at different positions on the second winding 112 between the first and second terminals T21, T22.

The impedance transforming circuit 100 further comprises a first programmable capacitor **C1** connected between the first and second terminals T11, T12 of the first winding 111 and a first set of switches **S1** connected to the number of taps on the first winding 111. The programmable capacitor **C1** is shunt with the first winding 111.

The impedance transforming circuit 100 further comprises a second programmable capacitor **C2** connected between the first and second terminals T21, T22 of the second winding 112 and a second set of switches **S2** connected to the number of taps on the second winding 112. The second programmable capacitor C2 is shunt with the second winding 112.

The first set of switches S1 is connected to a terminal of the first port P1 of the impedance transforming circuit 100 at a first side, e.g. the left side, the second set of switches S2 is connected to a terminal of the second port P2 of the circuit 100 at a second side, e.g. the right side. The impedance transforming circuit 100 may be connected between two circuits and transforms impedance between the two circuits. As shown in Figure 1, a first circuit **120** may be connected to the first port P1 and a second circuit **130** may be connected to the second port P2. The impedance transforming circuit 100 is configured to transform impedance by selectively connecting the first circuit 120 to one of the taps on the first winding 110 via the first set of switches S1 and selectively connecting the second circuit 130 to one of the taps on the second winding 112 via the second set of switches S2.

As can be seen the core of the impedance transforming circuit 100 is a tapped transformer 110. The first circuit 120 may be a transceiver and the second circuit 130 may be an antenna. Then the circuit 100 may be used as an antenna impedance tuner. By choosing different taps on the antenna and transceiver side different upwards or downwards transformation ratios may be achieved. To choose the taps there are switches S1, S2 on both sides. Using a Complementary Metal Oxide Semiconductor (CMOS) technology, the switches S1, S2 may be implemented by one transistor connected between each tap and the corresponding tuner terminal. In the example of Figure 1 there may be four transistors connected between the transceiver terminal and the taps of the first transformer winding 111, and another four transistors connected between the antenna terminal and the four taps of the second transformer winding 112. One transistor in each group of four transistors may then be turned on by applying a high potential to its gate. To improve linearity a large resistor may be applied in series between the control voltage and the gate terminal of each transistor.

As can be seen there are also controllable and programmable capacitors C1 and C2 used, the impedance transforming circuit 100 may be also configured to select capacitances of the first and second programmable capacitors. The programmable capacitors C1, C2 may be implemented as capacitor banks with switches to choose or set different capacitances needed. By setting their capacitance to resonate with the inductance of the transformer 110, the tuner will transform a real valued antenna impedance to a real valued transceiver impedance. If the antenna shows a complex impedance at the frequency of operation, however, the capacitance may be either increased or reduced from the resonance value, to handle inductive or capacitive antenna impedances. The antenna impedance that can be transformed to the nominal transceiver impedance then moves along a circle in the Smith chart. The larger the range over which the capacitances can be controlled the longer the arc that can be reached. There is, however, a tradeoff between capacitance tuning range and capacitor quality factor, i.e. the loss of the capacitor.

There are other tradeoffs in the design of the transformer 110. More taps implemented will result in more losses, but fewer taps will provide a less dense matching domain. A larger physical size will provide better coverage of higher impedances, but will increase chip area. There are also tradeoffs in the design of the switches, where larger switches will reduce losses, but at the same time reduce the size of the matching domain.

The circuit 100 for impedance transforming may be configured and used for different applications. Either the first terminal T11 or the second terminal T12 of the first winding 111 may for instance be connected to a reference voltage node, such as a signal ground. Either the first terminal T21 or the second terminal T22 of the second winding 112 may for instance be connected to a reference voltage node, such as a signal ground.

According to some embodiments herein, the circuit 100 for impedance transforming may be configured to a single-ended impedance tuner, where both the first and second ports are single-ended ports. **Figure 2** shows a single-ended impedance tuner **200.** As shown in Figure 2, one of the terminals on the first winding 111, e.g. the second terminal T12, and one of the terminals on the second winding 112, e.g. the second terminal T22, are connected to signal ground, and the taps on the first winding 111 may be connected to a transceiver **TRX 220** with single-ended port via the first set of switches S1, the taps on the second winding 112 may be connected to an antenna **230** with single-ended port via the second set of switches S2.

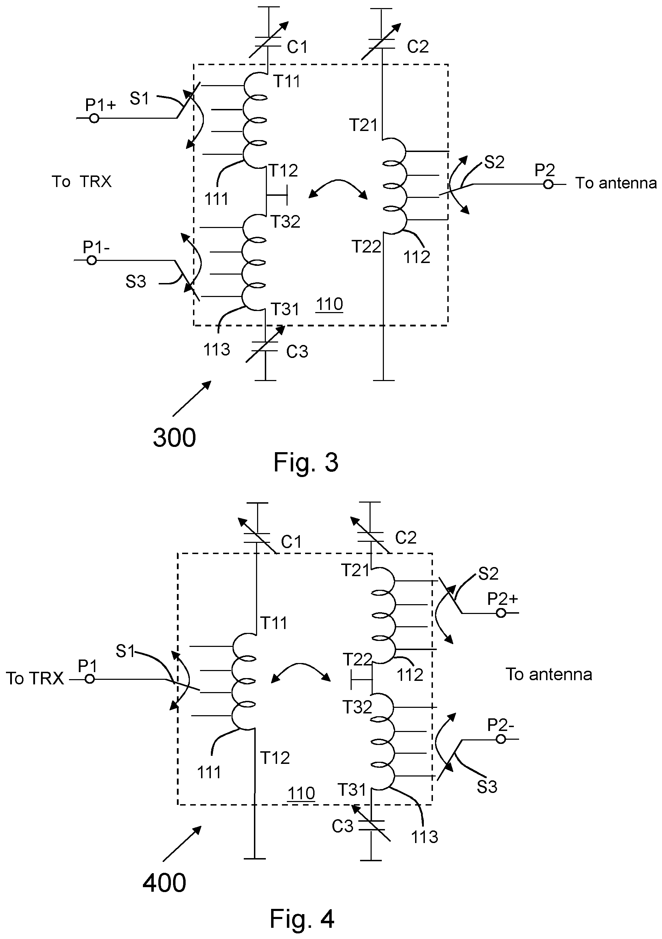

According to some embodiments herein, the circuit 100 for impedance transforming may be configured to a differential to single-ended impedance tuner, where the first port is a differential port and the second port is a single-ended port. **Figure 3** shows a differential to single-ended impedance tuner **300.** To be able to form a differential port, the tapped transformer 110 further comprises a third winding **113** with a number of taps and connected in series with the first winding 111 as shown in Figure 3. The third winding 113 has a similar structure as the first winding, i.e. has a first terminal **T31,** a second terminal **T32** and a number of taps connected at different positions on the third winding 113 between the first and second terminals. The differential to single-ended impedance tuner 300 further comprises a third set of switches **S3** and a third programmable capacitor **C3** connected in shunt with the third winding 113. That is the third programmable capacitor **C3** is connected between the first and second terminals of the third winding 113. The first programmable capacitor C1 and the third programmable capacitor C3 may be combined or configured as one programmable capacitor and connected between the first terminal T11 of the first winding 111 and the first terminal T31 of the third winding 113. The taps on the first and third windings are connected to the differential port P1+, P1- by the first and third switches S1, S3 respectively.

One of the terminals on the second winding 112, e.g. the second terminal T22 is connected to signal ground, thereby the terminal of the programmable capacitors C2 connected to the non-grounded terminal of the second winding 112 will get the same DC potential. The interconnection of the first and third windings, i.e. the connection of the second terminals of the first and third windings, is connected to signal ground, thereby the terminals of the first and third programmable capacitors C1, C3 connected to the non-grounded terminals of the windings will also get the same DC potential.

According to some embodiments herein, the circuit 100 for impedance transforming may be configured to a single-ended to differential impedance tuner. **Figure 4** shows a single-ended to differential impedance tuner **400,** where the first port P1 is a single-ended port and the second port P2 is a differential port **P2+, P2-.** To be able to form a differential port, the tapped transformer 110 further comprises a third winding 113 with a number of taps and connected in series with the second winding 112. The third winding 113 has a similar structure as the second winding 112, i.e. has a first terminal T31, a second terminal T32 and a number of taps connected at different positions on the third winding 113 between the first and second terminals. The single-ended to differential impedance tuner 400 further comprises a third set of switches **S3** and a third programmable capacitor C3 connected in shunt with the third winding 113. That is the third programmable capacitor C3 is connected between the first and second terminals of the third winding 113. The second programmable capacitor C2 and the third programmable capacitor C3 may be combined or configured as one programmable capacitor and connected between the first terminal T21 of the second winding 112 and the first terminal T31 of the third winding 113. The taps on the second and third windings are connected to the differential port P2+, P2- by the second and third switches (S2, S3) respectively.

One of the terminals on the first winding 111, e.g. the second terminal T12 is connected to signal ground, thereby the terminal of the programmable capacitors C1 connected to the non-grounded terminal of the first winding 111 will get the same DC potential. The interconnection of the second and third windings 112, 113, i.e. the connection of the second terminals T22, T32 of the second and third windings 112, 113, is connected to signal ground, thereby the terminals of the second and third programmable capacitors C2, C3 connected to the non-grounded terminals of the windings will also get the same DC potential.

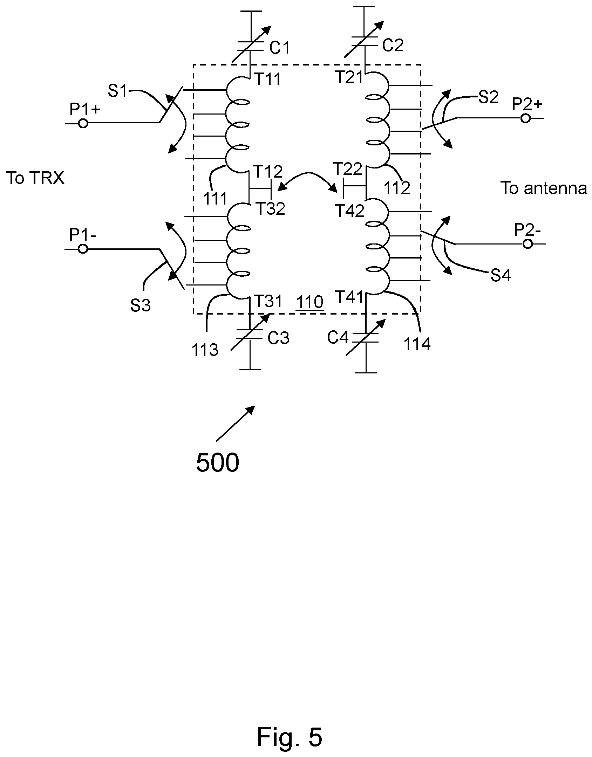

The circuit 100 for impedance transforming may be configured to a differential impedance tuner. **Figure 5** shows a differential impedance tuner **500,** where both the first and second ports P1, P2 are differential ports **P1+, P1-, P2+, P2-.** As shown in Figure 5, the tapped transformer 110 further comprises a third winding **113** with a number of taps and connected in series with the first winding 111, a fourth winding **114** with a number of taps and connected in series with the second winding 112. The third winding 113 has a similar structure as the first winding 111, i.e. has a first terminal T32, a second terminal T32 and a number of taps connected at different positions on the third winding 113 between the first and second terminals. The fourth winding 114 has a similar structure as the second winding 112, i.e. has a first terminal T41, a second terminal T42 and a number of taps connected at different positions on the fourth winding 114 between the first and second terminals. The differential impedance tuner 500 further comprises a third set of switches **S3,** a fourth set of switches **S4,** a third programmable capacitor **C3** connected in shunt with the third winding 113 and a fourth programmable capacitor **C4** connected in shunt with the fourth winding 114. The first programmable capacitor C1 and the third programmable capacitor C3 may be combined or configured as one programmable capacitor and connected between the first terminal T11 of the first winding 111 and the first terminal T31 of the third winding 113. The second programmable capacitor C2 and the fourth programmable capacitor C4 may be combined or configured as one programmable capacitor and connected between the first terminal T21 of the second winding 112 and the first terminal T41 of the fourth winding 114. The taps on the first and third windings 111, 113 are connected to the first differential port P1+, P1- by the first and third switches S1, S3 respectively. The taps on the second and fourth windings 112, 114 are connected to the second differential port P2+, P2- by the second and fourth switches S2, S4 respectively.

The interconnection of the first and third windings 111, 113, i.e. the connection of the second terminals T12, T32 of the first and third windings 111, 113, is connected to signal ground, thereby the terminals of the first and third programmable capacitors C1, C3 connected to the non-grounded terminals of the windings will get the same DC potential. The interconnection of the second and fourth windings 112, 114, i.e. the connection of the second terminals T22, T42 of the second and fourth windings 111, 113, is connected to signal ground, thereby the terminals of the second and fourth programmable capacitors C2, C4 connected to the non-grounded terminals of the windings will also get the same DC potential.

The circuit 100 for impedance transforming, the single-ended impedance tuner 200, the differential to single-ended impedance tuner 300, the single-ended to differential impedance tuner 400 and the differential impedance tuner 500 described above may be referred to generally hereafter as the impedance transforming circuits 100, 200, 300, 400, 500 according to embodiments herein.

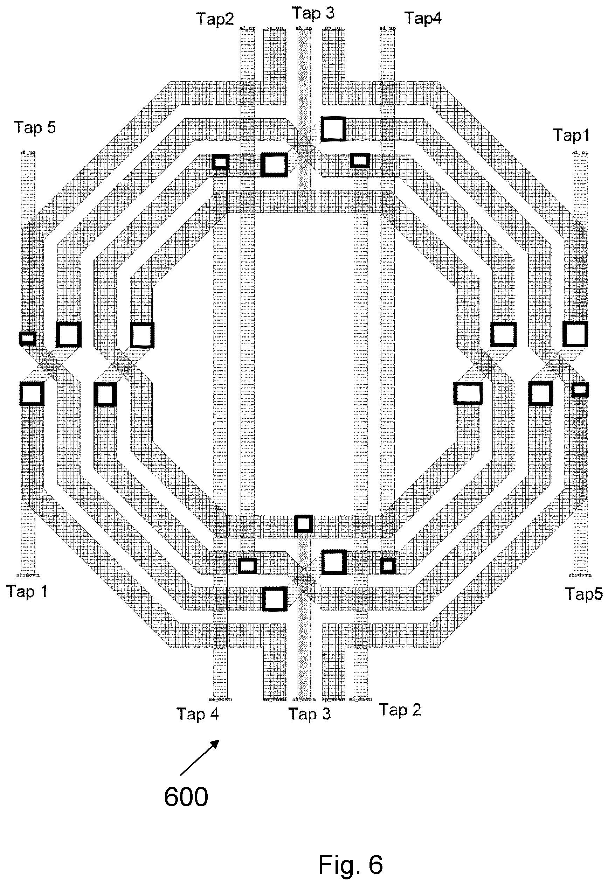

**Figure 6** shows an example layout of a tapped transformer **600** with a single-ended structure as the tapped transformer 110 shown in Figure 2. The tapped transformer 600 comprises two interleaved windings; each winding has two turns and 5 taps. The taps indicated by Tap 1, Tap 2, Tap 3, Tap 4, Tap 5 on the top of the layout are on the first winding, and the taps indicated by Tap 1, Tap 2, Tap 3, Tap 4, Tap 5 on the bottom of the layout are on the second winding.

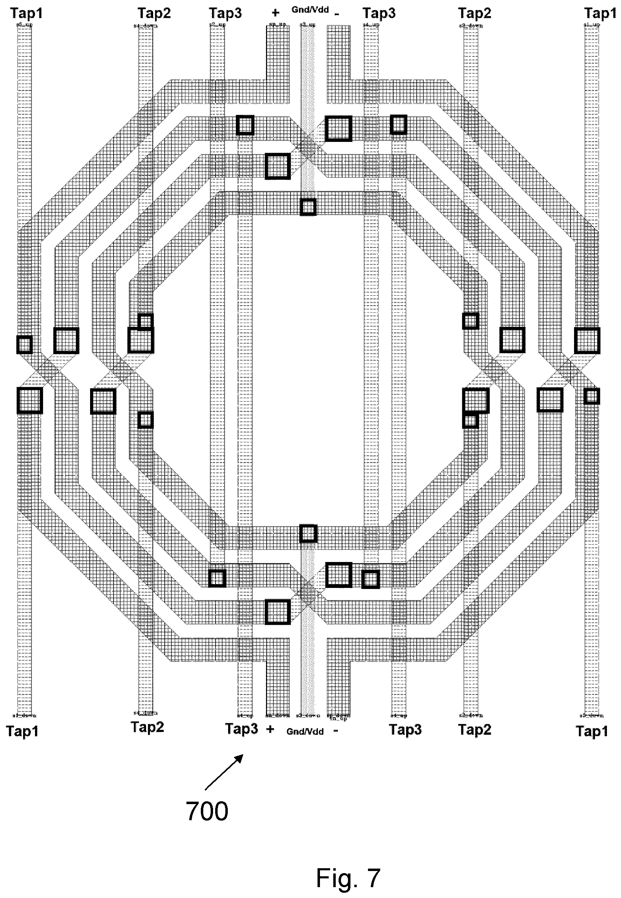

**Figure 7** shows an example layout of a tapped transformer **700** with a fully differential structure as the tapped transformer 110 shown in Figure 5. The tapped transformer 700 comprises four interleaved windings, each winding has 3 taps. The taps indicated by Tap 1, Tap 2, Tap 3 on the top left of the layout are on the first winding, and the taps indicated by Tap 1, Tap 2, Tap 3 on the top right of the layout are on the second winding. The taps indicated by Tap 1, Tap 2, Tap 3 on the bottom left of the layout are on the third winding, and the taps indicated by Tap 1, Tap 2, Tap 3 on the bottom right of the layout are on the fourth winding.

To demonstrate the performance and advantages of the impedance transforming circuit 100, 200, 300, 400, 500 that may be reached in an actual implementation, the impedance transforming circuit 100, 200, 300, 400, 500 is simulated in a Fully Depleted Silicon on Insulator (FDSOI) CMOS design-kit. The switches used both in the taps and the programmable capacitors are the RF low threshold voltage NMOS devices. The layout of the tapped transformer 600 shown in Figure 6 is modelled in the electromagnetic simulation tool Momentum, and then co-simulated with the impedance tuner in a circuit simulator, the Spectre^{®} Simulation Platform provided by Cadence^{®}.

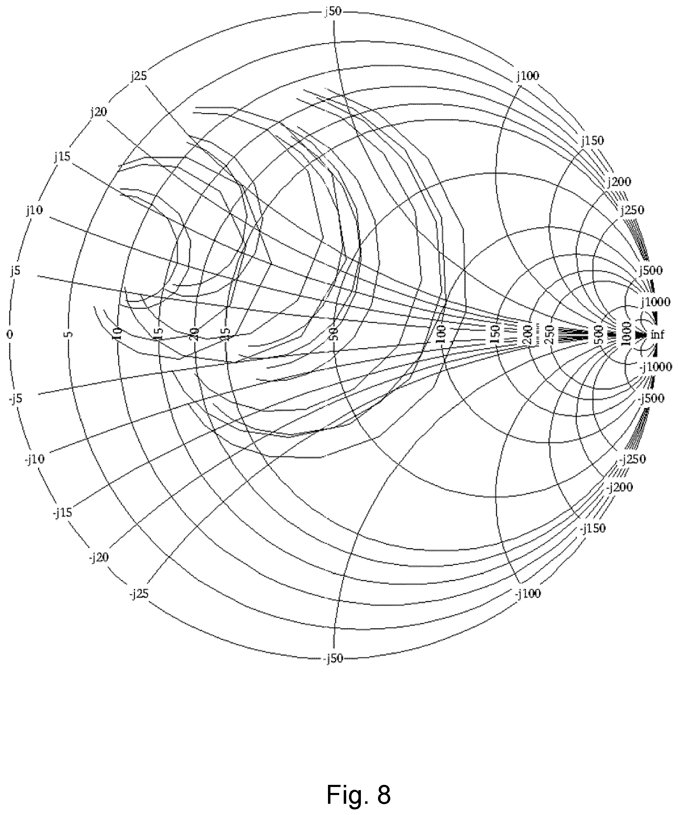

A frequency of 5GHz is chosen for the simulation of the impedance tuner. The matching domain is shown by the Smith chart in **Figure 8****.** As can be seen in the figure the matching circle arcs cover the center of the Smith chart and extend to an impedance ratio of about 4 (higher in some directions and lower in some). Lowering the tap position of the second winding moves the circle arc to the left and increasing the capacitance moves the impedance along the circle arc from top to bottom. The tuner loss at different impedance levels are shown in **Table 1.** Symmetric layout was used in the transformer for faster implementation, this results in a less optimal tuner loss performance as the Q-factor of the resonator connected to the antenna needs to be optimized to be larger to handle large voltage standing wave ration (VSWR) such as 4. An optimized layout of the inductor with improved Q-factor at the antenna side, where impedance values can be large, will result in lower loss. However, the presented loss is still competitive for an on-chip antenna tuner at 5GHz.

**Table 1**

| Impedance (Ω) | Tuner loss (dB) | Comment |
|---|---|---|
| 10-j15.5 | 3 | |
| 50 | 2.2 | |
| 149-j27 | 3.7 | Transformer loss is the limiting factor. |

The linearity of the tuner is solely determined by the linearity of the switches used. For low power applications with maximum output power close to e.g. 0 dBm, only one switch device is used for each of the inductor winding taps as well as the capacitor banks. The linearity simulations, mainly third order intercept point (IIP3) and input referred compression point (ICP), are tabulated in **Table 2.** Considering that only one switch device is used the values for IIP3 and ICP are as expected. If, however, higher linearity requirements are posed then the well-known technique of series switch device stacking may be used to improve the IIP3 and ICP. For example, eight series switch devices may be used to improve the overall linearity.

**Table 2**

| Impedance (Ω) | IIP3 (dBm) | ICP (dBm) | Comments |
|---|---|---|---|
| 10-j15.5 | 22 | 5.3 | |
| 50 | 21.41 | 4.423 | |
| 149-j27 | 17 | .6 | Due to high impedance IIP3 and ICP are reduced. |

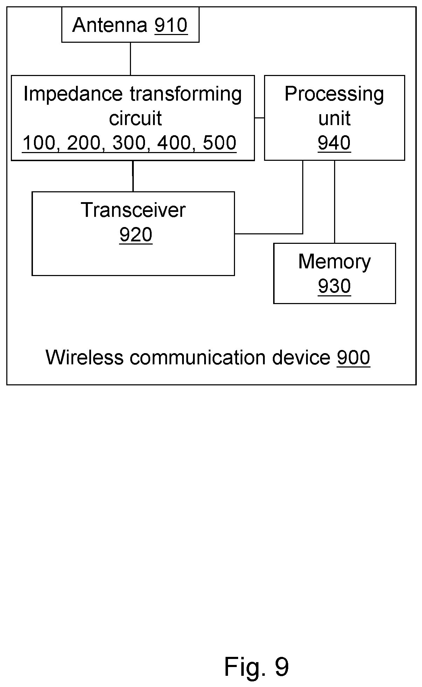

The impedance transforming circuits 100, 200, 300, 400, 500 according to embodiments herein may be employed in various integrated circuits, electronic circuits or devices, communication devices or apparatus. The impedance transforming circuits 100, 200, 300, 400, 500 according to embodiments herein are highly useful in for instance full-duplex short-range communication transceivers. **Figure 9** shows a block diagram of a wireless communication device **900** in which the impedance transforming circuits 100, 200, 300, 400, 500 according to embodiments herein may be implemented. The wireless communication device comprises an antenna 910, a transceiver 920, an impedance transforming circuit 100, 200, 300, 400, 500 according to embodiments herein. The wireless communication device 900 may comprise other units, where a memory **930,** and a processing unit **940** are shown. The wireless communication device 900 may be a user equipment or a mobile device for a cellular communication system. User equipment is a nonlimiting term which means any terminal, wireless communication terminal, Machine Type Communication (MTC) device, Device to Device (D2D) terminal, or node e.g. smart phone, laptop, mobile phone, sensor, relay, mobile tablets or even a small base station communicating within a cell.

To summarize, the impedance transforming circuits 100, 200, 300, 400, 500 according to embodiments herein are very compact and suitable for full integration. The losses are also low which is attractive for a fully integrated tuner. So the impedance transforming circuits 100, 200, 300, 400, 500 according to embodiments herein may be fully integrated on chip. The structure of the impedance transforming circuits 100, 200, 300, 400, 500 is based on a single tapped transformer, together with switches and programmable capacitors. The core of the tuner is a tapped transformer, with multiple taps on both windings. By using switches to connect to different taps on the two transformer sides, the antenna impedance may be transformed both up and down. Transformer windings at both sides are shunted with programmable capacitors. If these capacitors are set to resonate with the inductance of the transformer at the operating frequency, the tuner transforms between real valued impedances. The transformation ratio may be programmed by the switches selecting different taps for connection to the tuner ports. If transformation from complex antenna impedance to real valued impedance is desired, the capacitors may be programmed to a smaller or larger value than the resonance value. The impedance will then move along a circle in the Smith chart, sweeping over the capacitive and inductive half. Sweeping the capacitance for the different tap settings will create non-overlapping circle arcs covering an area of the Smith chart. This represents a matching domain that is unusually well-ordered, and thus supports simpler control of the impedance tuner. So the matching domain is very regular and has just two main parameters to control. This simplifies control algorithms, and still makes it possible to reach a wide matching domain.

Those skilled in the art will understand that the impedance transforming circuits 100, 200, 300, 400, 500 according to embodiments herein may be implemented by any semiconductor technology, e.g. Bi-polar, N-type Metal Oxide Semiconductor (NMOS), P-type Metal Oxide Semiconductor (PMOS), Complementary Metal Oxide Semiconductor (CMOS), Silicon on Insulator (SOI) CMOS, fin field-effect transistor (finFET), MOSFET or Micro-Electro-Mechanical Systems (MEMS) technology etc.

The word "comprise" or "comprising", when used herein, shall be interpreted as nonlimiting, i.e. meaning "consist at least of".

The embodiments herein are not limited to the above described preferred embodiments. Various alternatives, modifications and equivalents may be used. Therefore, the above embodiments should not be taken as limiting the scope of the invention, which is defined by the appended claims.

## Claims

1. A chip having integrated thereon a circuit (100), the circuit (100) comprising:
a first port (P1) and a second port (P2);
a tapped transformer (110) comprising a first winding (111) and a second winding (112);
wherein the first winding (111) comprises a first terminal (T11), a second terminal (T12), and a number of taps (Tp11, Tp12,...) connected at different positions on the first winding (111) between the first and second terminals (T11, T12) of the first winding (111), and
the second winding (112) comprises a first terminal (T21), a second terminal (T22), and a number of taps (Tp21, Tp22...) connected at different positions on the second winding (112) between the first and second terminals (T21, T22) of the second winding (112);
a first programmable capacitor (C1) connected between the first and second terminals of the first winding (111);
a first set of switches (S1) connected between the number of taps on the first winding (111) and a terminal of the first port (P1);
a second programmable capacitor (C2) connected between the first and second terminals of the second winding (112); and
a second set of switches (S2) connected between the number of taps on the second winding (112) and a terminal of the second port (P2)

2. The chip according to claim 1, wherein the circuit (100) is further configured to select capacitances of the first and second programmable capacitors (C1, C2).

3. The chip according to any one of claims 1-2, wherein the circuit (100) is configured as a single-ended antenna impedance tuner (200), where both the first and second ports are single-ended ports, wherein one of the terminals (T12) on the first winding (111) and one of the terminals (T22) on the second winding (112) are connected to signal ground, and the first port is to be connected to a transceiver with a single-ended port and the second port is to be connected to a single-ended antenna port.

4. The chip according to any one of claims 1-2, wherein the circuit (100) is configured as a differential to single-ended impedance tuner (300), where the first port (P1) is a differential port (P1+, P1-) and the second port (P2) is a single-ended port, and wherein the tapped transformer (110) further comprises a third winding (113) with a first terminal (T31), a second terminal (T32) and a number of taps and connected in series with the first winding (111), the differential to single-ended impedance tuner (300) further comprises a third set of switches (S3) and a third programmable capacitor (C3) connected in shunt with the third winding (113), and the taps on the first and third windings are connected to the differential port (P1+, P1-) by the first and third switches (S1, S3) respectively.

5. The chip according to claim 4, wherein the first programmable capacitor (C1) and the third programmable capacitor (C3) are configured as one programmable capacitor and connected between the first terminal (T11) of the first winding (111) and the first terminal (T31) of the third winding (113).

6. The chip according to any one of claims 1-2, wherein the circuit (100) is configured as a single-ended to differential impedance tuner (400), where the first port (P1) is a single-ended port and the second port (P2) is a differential port (P2+, P2-), and wherein the tapped transformer (110) further comprises a third winding (113) with a first terminal (T31), a second terminal (T32) and a number of taps and connected in series with the second winding (112), the single-ended to differential impedance tuner (400) further comprises a third set of switches (S3) and a third programmable capacitor (C3) connected in shunt with the third winding (113), and the taps on the second and third windings are connected to the differential port (P2+, P2-) by the second and third switches (S2, S3) respectively.

7. The chip according to claim 6, wherein the second programmable capacitor (C2) and the third programmable capacitor (C3) are configured as one programmable capacitor and connected between the first terminal (T21) of the second winding (112) and the first terminal (T31) of the third winding (113).

8. The chip according to any one of claims 1-2, wherein the circuit (100) is configured as a differential impedance tuner (500), where both the first and second ports (P1, P2) are differential ports (P1+, P1-, P2+, P2-), and wherein the tapped transformer (110) further comprises a third winding (113) with a number of taps and connected in series with the first winding (111), and a fourth winding (114) with a number of taps and connected in series with the second winding (112), the differential impedance tuner (500) further comprises a third set of switches (S3), a fourth set of switches (S4), a third programmable capacitor (C3) connected in shunt with the third winding (113) and a fourth programmable capacitor (C4) connected in shunt with the fourth winding (114), and the taps on the first and third windings are connected to the first differential port (P1+, P1-) by the first and third switches (S1, S3) respectively, the taps on the second and fourth windings are connected to the second differential port (P2+, P2-) by the second and fourth switches (S2, S4) respectively.

9. The chip according to claim 8, wherein the first programmable capacitor (C1) and the third programmable capacitor (C3) is configured as one programmable capacitor and connected between the first terminal (T11) of the first winding (111) and the first terminal (T31) of the third winding (113), the second programmable capacitor (C2) and the fourth programmable capacitor (C4) is configured as one programmable capacitor and connected between the first terminal (T21) of the second winding (112) and the first terminal (T41) of the fourth winding (114).

10. The chip according to any preceding claim, wherein the circuit (100) is configured to transform impedance between a first circuit (120) connected to the first port (P1) and a second circuit (130) connected to the second port (P2) by selectively connecting the first circuit (120) to one of the taps on the first winding (111) via the first set of switches (S1) and selectively connecting the second circuit (112) to one of the taps on the second windings (112) via the second set of switches (S2).

11. A wireless communication device comprising the chip according to any one of claims 1-10.

12. The wireless communication device according to claim 11, wherein the wireless communication device is a user equipment.

## Patentansprüche

1. Chip, der einen darauf integrierten Schaltkreis (100) aufweist, wobei der Schaltkreis (100) Folgendes umfasst:
einen ersten Port (P1) und einen zweiten Port (P2);
einen angezapften Transformator (110), umfassend eine erste Wicklung (111) und eine zweite Wicklung (112);
wobei die erste Wicklung (111) einen ersten Anschluss (T11), einen zweiten Anschluss (T12) und eine Anzahl an Anzapfungen (Tp11, Tp12,...) umfasst, die an unterschiedlichen Positionen auf der ersten Wicklung (111) zwischen dem ersten und dem zweiten Anschluss (T11, T12) der ersten Wicklung (111) geschaltet sind, und
die zweite Wicklung (112) einen ersten Anschluss (T21), einen zweiten Anschluss (T22) und eine Anzahl an Anzapfungen (Tp21, Tp22...) umfasst, die an unterschiedlichen Positionen auf der zweiten Wicklung (112) zwischen dem ersten und dem zweiten Anschluss (T21, T22) der zweiten Wicklung (112) geschaltet sind;
einen ersten programmierbaren Kondensator (C1), der zwischen dem ersten und dem zweiten Anschluss der ersten Wicklung (111) geschaltet ist;
einen ersten Satz von Schaltern (S1), der zwischen der Anzahl an Anzapfungen auf der ersten Wicklung (111) und einem Anschluss des ersten Ports (P1) geschaltet ist;
einen zweiten programmierbaren Kondensator (C2), der zwischen dem ersten und dem zweiten Anschluss der zweiten Wicklung (112) geschaltet ist; und
einen zweiten Satz von Schaltern (S2), der zwischen der Anzahl an Anzapfungen auf der zweiten Wicklung (112) und einem Anschluss des zweiten Ports (P2) geschaltet ist.

2. Chip nach Anspruch 1, wobei der Schaltkreis (100) ferner dazu konfiguriert ist, Kapazitäten des ersten und des zweiten programmierbaren Kondensators (C1, C2) auszuwählen.

3. Chip nach einem der Ansprüche 1-2, wobei der Schaltkreis (100) als ein unsymmetrischer Antennenimpedanzabstimmer (200) konfiguriert ist, wobei sowohl der erste als auch der zweite Port unsymmetrische Ports sind, wobei einer der Anschlüsse (T12) auf der ersten Wicklung (111) und einer der Anschlüsse (T22) auf der zweiten Wicklung (112) mit einem Erdleiter verbunden sind und der erste Port mit einem Sendeempfänger mit einem unsymmetrischen Port zu verbinden ist und der zweite Port mit einem unsymmetrischen Antennenport zu verbinden ist.

4. Chip nach einem der Ansprüche 1-2, wobei der Schaltkreis (100) als ein Differenziell-zu-Unsymmetrisch-Impendanzabstimmer (300) konfiguriert ist, wobei der erste Port (P1) ein differenzieller Port (P1+, P1-) ist und der zweite Port (P2) ein unsymmetrischer Port ist und wobei der angezapfte Transformator (110) ferner eine dritte Wicklung (113) mit einem ersten Anschluss (T31), einem zweiten Anschluss (T32) und einer Anzahl an Anzapfungen, und die mit der ersten Wicklung (111) in Reihe geschaltet ist, umfasst, der Differenziell-zu-Unsymmetrisch-Impedanzabstimmer (300) ferner einen dritten Satz von Schaltern (S3) und einen dritten programmierbaren Kondensator (C3), der mit der dritten Wicklung (113) parallel geschaltet ist, umfasst und die Anzapfungen auf der ersten und der dritten Wicklung durch den ersten beziehungsweise den dritten Schalter (S1, S3) mit dem differenziellen Port (P1+, P1-) verbunden sind.

5. Chip nach Anspruch 4, wobei der erste programmierbare Kondensator (C1) und der dritte programmierbare Kondensator (C3) als ein programmierbarer Kondensator konfiguriert und zwischen dem ersten Anschluss (T11) der ersten Wicklung (111) und dem ersten Anschluss (T31) der dritten Wicklung (113) geschaltet sind.

6. Chip nach einem der Ansprüche 1-2, wobei der Schaltkreis (100) als ein Unsymmetrisch-zu-Differenziell-Impendanzabstimmer (400) konfiguriert ist, wobei der erste Port (P1) ein unsymmetrischer Port ist und der zweite Port (P2) ein differenzieller Port (P2+, P2-) ist und wobei der angezapfte Transformator (110) ferner eine dritte Wicklung (113) mit einem ersten Anschluss (T31), einem zweiten Anschluss (T32) und einer Anzahl an Anzapfungen, und die mit der zweiten Wicklung (112) in Reihe geschaltet ist, umfasst, der Unsymmetrisch-zu-Differenziell-Impedanzabstimmer (400) ferner einen dritten Satz von Schaltern (S3) und einen dritten programmierbaren Kondensator (C3), der mit der dritten Wicklung (113) parallel geschaltet ist, umfasst und die Anzapfungen auf der ersten und der dritten Wicklung durch den zweiten beziehungsweise den dritten Schalter (S2, S3) mit dem differenziellen Port (P2+, P2-) verbunden sind.

7. Chip nach Anspruch 6, wobei der zweite programmierbare Kondensator (C2) und der dritte programmierbare Kondensator (C3) als ein programmierbarer Kondensator konfiguriert und zwischen dem ersten Anschluss (T21) der zweiten Wicklung (112) und dem ersten Anschluss (T31) der dritten Wicklung (113) geschaltet sind.

8. Chip nach einem der Ansprüche 1-2, wobei der Schaltkreis (100) als ein differenzieller Impedanzabstimmer (500) konfiguriert ist, wobei sowohl der erste als auch der zweite Port (P1, P2) differenzielle Ports (P1+, P1-, P2+, P2-) sind und wobei der angezapfte Transformator (110) ferner eine dritte Wicklung (113) mit einer Anzahl an Anzapfungen, und die mit der ersten Wicklung (111) in Reihe geschaltet ist, und eine vierte Wicklung (114) mit einer Anzahl an Anzapfungen, und die mit der zweiten Wicklung (112) in Reihe geschaltet ist, umfasst, der differenzielle Impedanzabstimmer (500) ferner einen dritten Satz von Schaltern (S3), einen vierten Satz von Schaltern (S4), einen dritten programmierbaren Kondensator (C3), der mit der dritten Wicklung (113) parallel geschaltet ist, und einen vierten programmierbaren Kondensator (C4), der mit der vierten Wicklung (114) parallel geschaltet ist, umfasst und die Anzapfungen auf der ersten und der dritten Wicklung durch den ersten beziehungsweise den dritten Schalter (S1, S3) mit dem ersten differenziellen Port (P1+, P1-) verbunden sind und die Anzapfungen auf der zweiten und der vierten Wicklung durch den zweiten beziehungsweise den vierten Schalter (S2, S4) mit dem zweiten differenziellen Port (P2+, P2-) verbunden sind.

9. Chip nach Anspruch 8, wobei der erste programmierbare Kondensator (C1) und der dritte programmierbare Kondensator (C3) als ein programmierbarer Kondensator konfiguriert und zwischen dem ersten Anschluss (T11) der ersten Wicklung (111) und dem ersten Anschluss (T31) der dritten Wicklung (113) geschaltet sind und der zweite programmierbare Kondensator (C2) und der vierte programmierbare Kondensator (C4) als ein programmierbarer Kondensator und zwischen dem ersten Anschluss (T21) der zweiten Wicklung (112) und dem ersten Anschluss (T41) der vierten Wicklung (114) geschaltet sind.

10. Chip nach einem der vorhergehenden Ansprüche, wobei der Schaltkreis (100) dazu konfiguriert ist, eine Impedanz zwischen einem ersten Schaltkreis (120), der mit dem ersten Port (P1) verbunden ist, und einem zweiten Schaltkreis (130), der mit dem zweiten Port (P2) verbunden ist, durch selektives Verbinden des ersten Schaltkreises (120) mit einer der Anzapfungen auf der ersten Wicklung (111) über den ersten Satz von Schaltern (S1) und selektives Verbinden des zweiten Schaltkreises (112) mit einer der Anzapfungen auf den zweiten Wicklungen (112) über den zweiten Satz von Schaltern (S2) zu transformieren.

11. Drahtlose Kommunikationsvorrichtung, umfassend den Chip nach einem der Ansprüche 1-10.

12. Drahtlose Kommunikationsvorrichtung nach Anspruch 11, wobei die drahtlose Kommunikationsvorrichtung eine Benutzereinrichtung ist.

## Revendications

1. Puce ayant un circuit (100) intégré sur celle-ci, le circuit (100) comprenant :
un premier port (P1) et un deuxième port (P2) ;
un transformateur à prises (110) comprenant un premier enroulement (111) et un deuxième enroulement (112) ;
dans lequel le premier enroulement (111) comprend une première borne (T11), une deuxième borne (T12), et un certain nombre de prises (Tp11, Tp12, ...) connectées à différentes positions sur le premier enroulement (111) entre les première et deuxième bornes (T11, T12) du premier enroulement (111), et
le deuxième enroulement (112) comprend une première borne (T21), une deuxième borne (T22), et un certain nombre de prises (Tp21, Tp22...) connectées à différentes positions sur le deuxième enroulement (112) entre les première et deuxième bornes (T21, T22) du deuxième enroulement (112) ;
une première capacité programmable (C1) connectée entre les première et deuxième bornes du premier enroulement (111) ;
un premier ensemble de commutateurs (S1) connectés entre le nombre de prises sur le premier enroulement (111) et une borne du premier port (P1) ;
une deuxième capacité programmable (C2) connectée entre les première et deuxième bornes du deuxième enroulement (112) ; et
un deuxième ensemble de commutateurs (S2) connectés entre le nombre de prises sur le deuxième enroulement (112) et une borne du deuxième port (P2).

2. Puce selon la revendication 1, dans laquelle le circuit (100) est en outre configuré pour sélectionner des capacités des première et deuxième capacités programmables (C1, C2).

3. Puce selon l'une quelconque des revendications 1 à 2, dans laquelle le circuit (100) est configuré comme un syntoniseur d'impédance d'antenne asymétrique (200), où les premier et deuxième ports sont des ports asymétriques, dans laquelle l'une des bornes (T12) sur le premier enroulement (111) et l'une des bornes (T22) sur le deuxième enroulement (112) sont connectées à la masse de signal, et le premier port doit être connecté à un émetteur-récepteur avec un port asymétrique et le deuxième port doit être connecté à un port d'antenne asymétrique.

4. Puce selon l'une quelconque des revendications 1 à 2, dans laquelle le circuit (100) est configuré comme un syntoniseur d'impédance différentiel à asymétrique (300), où le premier port (P1) est un port différentiel (P1+, P1-) et le deuxième port (P2) est un port asymétrique, et dans laquelle le transformateur à prises (110) comprend en outre un troisième enroulement (113) avec une première borne (T31), une deuxième borne (T32) et un certain nombre de prises et connecté en série avec le premier enroulement (111), le syntoniseur d'impédance différentiel à asymétrique (300) comprend en outre un troisième ensemble de commutateurs (S3) et une troisième capacité programmable (C3) connectée en dérivation avec le troisième enroulement (113), et les prises sur les premier et troisième enroulements sont connectées au port différentiel (P1+, P1-) par les premier et troisième commutateurs (S1, S3) respectivement.

5. Puce selon la revendication 4, dans laquelle la première capacité programmable (C1) et la troisième capacité programmable (C3) sont configurées comme une seule capacité programmable et connectée entre la première borne (T11) du premier enroulement (111) et la première borne (T31) du troisième enroulement (113).

6. Puce selon l'une quelconque des revendications 1 à 2, dans laquelle le circuit (100) est configuré comme un syntoniseur d'impédance asymétrique à différentiel (400), où le premier port (P1) est un port asymétrique et le deuxième port (P2) est un port différentiel (P2+, P2-), et dans laquelle le transformateur à prises (110) comprend en outre un troisième enroulement (113) avec une première borne (T31), une deuxième borne (T32) et un certain nombre de prises et connecté en série avec le deuxième enroulement (112), le syntoniseur d'impédance asymétrique à différentiel (400) comprend en outre un troisième ensemble de commutateurs (S3) et une troisième capacité programmable (C3) connectée en dérivation avec le troisième enroulement (113), et les prises sur les deuxième et troisième enroulements sont connectées au port différentiel (P2+, P2-) par les deuxième et troisième commutateurs (S2, S3) respectivement.

7. Puce selon la revendication 6, dans laquelle la deuxième capacité programmable (C2) et la troisième capacité programmable (C3) sont configurées comme une seule capacité programmable et connectée entre la première borne (T21) du deuxième enroulement (112) et la première borne (T31) du troisième enroulement (113).

8. Puce selon l'une quelconque des revendications 1 à 2, dans laquelle le circuit (100) est configuré comme un syntoniseur d'impédance différentiel (500), où les premier et deuxième ports (P1, P2) sont des ports différentiels (P1+, P1-, P2+, P2-), et dans laquelle le transformateur à prises (110) comprend en outre un troisième enroulement (113) avec un certain nombre de prises et connecté en série avec le premier enroulement (111), et un quatrième enroulement (114) avec un certain nombre de prises et connecté en série avec le deuxième enroulement (112), le syntoniseur d'impédance différentiel (500) comprend en outre un troisième ensemble de commutateurs (S3), un quatrième ensemble de commutateurs (S4), une troisième capacité programmable (C3) connectée en dérivation avec le troisième enroulement (113) et une quatrième capacité programmable (C4) connectée en dérivation avec le quatrième enroulement (114), et les prises sur les premier et troisième enroulements sont connectées au premier port différentiel (P1+, P1-) par les premier et troisième commutateurs (S1, S3) respectivement, les prises sur les deuxième et quatrième enroulements sont connectées au deuxième port différentiel (P2+, P2-) par les deuxième et quatrième commutateurs (S2, S4) respectivement.

9. Puce selon la revendication 8, dans laquelle la première capacité programmable (C1) et la troisième capacité programmable (C3) sont configurées comme une seule capacité programmable et connectée entre la première borne (T11) du premier enroulement (111) et la première borne (T31) du troisième enroulement (113), la deuxième capacité programmable (C2) et la quatrième capacité programmable (C4) sont configurées comme une seule capacité programmable et connectée entre la première borne (T21) du deuxième enroulement (112) et la première borne (T41) du quatrième enroulement (114).

10. Puce selon l'une quelconque des revendications précédentes, dans laquelle le circuit (100) est configuré pour transformer l'impédance entre un premier circuit (120) connecté au premier port (P1) et un deuxième circuit (130) connecté au deuxième port (P2) en connectant sélectivement le premier circuit (120) à l'une des prises sur le premier enroulement (111) via le premier ensemble de commutateurs (S1) et en connectant sélectivement le deuxième circuit (112) à l'une des prises sur les deuxièmes enroulements (112) via le deuxième ensemble de commutateurs (S2) .

11. Dispositif de communication sans fil comprenant la puce selon l'une quelconque des revendications 1 à 10.

12. Dispositif de communication sans fil selon la revendication 11, dans lequel le dispositif de communication sans fil est un équipement utilisateur.
